Europäisches Patentamt

European Patent Office

Office européen des brevets

(19)

(11) Veröffentlichungsnummer : **0 441 785 B1**

(12) **EUROPÄISCHE PATENTSCHRIFT**

(45) Veröffentlichungstag der Patentschrift :
15.07.92 Patentblatt 92/29

(51) Int. Cl.$^5$ : **H01L 23/10, B21D 51/52**

(21) Anmeldenummer : 89908164.0

(22) Anmeldetag : 20.07.89

(86) Internationale Anmeldenummer :
PCT/EP89/00852

(87) Internationale Veröffentlichungsnummer :
WO 90/05378 17.05.90 Gazette 90/11

(54) HERSTELLUNGSVERFAHREN FÜR HYBRIDSCHALTKREISGEHÄUSE.

(30) Priorität : 03.11.88 DE 3837301
13.02.89 DE 3904219

(43) Veröffentlichungstag der Anmeldung :
21.08.91 Patentblatt 91/34

(45) Bekanntmachung des Hinweises auf die
Patenterteilung :
15.07.92 Patentblatt 92/29

(84) Benannte Vertragsstaaten :
AT DE FR GB

(56) Entgegenhaltungen :
FR-A- 1 511 937
FR-A- 2 216 751
PATENT ABSTRACTS OF JAPAN, Band 7, No.
283 (M-263)(1428), 16. Dezember 1983; & JP-
A-58157527

(73) Patentinhaber : TECHNOTRON
elektrotechnische Geräte und Komponenten
GmbH & Co. KG
Werner-von-Siemens-Strasse 62
W-8450 Amberg (DE)

(72) Erfinder : MEISLITZER, Karl-Heinz
Schwaiger Strasse 23 A
W-8450 Amberg (DE)

(74) Vertreter : Hanewinkel, Lorenz, Dipl.-Phys.
Patentanwalt Ferrariweg 17a
W-4790 Paderborn (DE)

## Beschreibung

Die Erfindung betrifft ein Herstellungsverfahren für ein Gehäuse, insbes. zur Aufnahme eines Hybridschaltkreises, durch eine Verformung eines Zuschnittes eines Bleches zu einer Gehäusewanne, ein anschließendes Einbringen von Löchern in diese Gehäusewanne, ein Einschmelzen je einer Durchführung mittels einer Glaseinschmelzung in die Löcher, ein Planschleifen der Randfläche der Gehäusewannenwandung und danach ein dichtes Hartverlöten des Gehäuses mit einem Deckel, der in einer umlaufenden Ausnehmung einen Randbereich der Gehäusewannenwandung aufnimmt.

Ein derartiges Hybridschaltkreisgehäuse ist bekannt, das wegen der hohen technischen Anforderungen an eine Langlebensdauer und an Härtetestbedingungen, insbesondere an die Dichtigkeit der Glasmetallverbindungen der Kontaktdurchführungen, die zwischen einer Eisen-Kobalt-Nickellegierung des Gehäuses und Borsilikatgläsern der Einschmelzungen mit aneinander angepaßten Wärmeausdehnungakoeffizienten hergestellt werden, durch Tiefziehen einer Gehäusewanne und Stanzen der Löcher in Serienfertigung hergestellt wird, wobei die genannten Materialien für den Herstell- und den Verbindungsprozeß geeignet aufbereitet werden. Das Gehäusematerial ist im normalen Schmelzverfahren nicht herstellbar; sondern es wird nach einem pulvermetallurgischen Preßverfahren und/oder einem Vakuumschmelzverfahren in Blechstreifenform erzeugt und unter Luftabschluß geglüht, so daß es dadurch zäh, duktil und homogen wird und mit Einschränkungen tiefziehfähig ist. Dieses Tiefziehen zu der Gehäusewanne kann nur bis zu einer geringen Ziehhöhe von maximal 6 mm in mehreren Ziehschritten auf sehr teuren Werkzeugen erfolgen, wobei ein Werkzeugsatz nur für eine Gehäuseform verwendbar ist. Die Löcher für die Elektrodendurchführungen werden üblicher Weise über ein jeweils zu einem Tiefziehwerkzeugsatz passenden Stanzstempelwerkzeug eingebracht, wobei sich jedoch häufig Stempelbrüche ereignen, da die Stempeldurchmesser sehr klein sind und das Gehäusematerial in der vandseitigen Bodenzone, in die die Löcher einzubringen sind, durch das Tiefziehen inhomogen verfestigt ist.

Diese bekannte Herstellungmethode ist nicht geeignet, die vielfältigen Anforderungen von geeigneten Gehäusen für die Raumfahrtechnik, Medizin- und Meßelektronik, die häufig nur in kleinen Stückzahlen und mit besonderen Abmessungen und spezieller Lage und/oder Zahlen der Kontaktdurchführungen benötigt werden, zu befriedigen.

Es ist Aufgabe der Erfindung, ein Herstellungsverfahren für Hybridschaltkreisgehörige höchster Qualitätsanforderungen zu offenbaren, das eine kostengünstige Herstellung auch kleiner Stückzahlen von Sonderkonstruktionen bezüglich der Abmessungen und Kontaktlage und -anzahl ermöglicht.

Die Lösung der Aufgabe besteht darin, daß der Zuschnitt jeweils in den Eckbereichen ausgeklinkt oder freigeschnitten wird, so daß sich an dem Zuschnitt freistehende Seitenteile erstrecken, die, die Seitenteile der Gehäusewanne bildend, danach jeweils in einem Biegearbeitsgang zu an einen Gehäuseboden anschließenden Seitenwänden abgewinkelt werden, so daß jeweils die benachbarten Seitenwände mit einem engen Spalt zueinander stehen, wonach diese Spalte durch ein Hartlöten verschlossen werden, woran sich das Einbringen der Löcher anschließt.

Vorteilhafte Ausgestaltungen sind in den Unteransprüchen angegeben.

Eine erste Verfahrensausgestaltung betrifft die Herstellung von Gehäusen aus einem rechteckigen Zuschnitt, der durch rechteckiges Ausklinken der Ecken kreuzförmige Armpaare bildende Seitenteile erhält, die paarweise abgewinkelt werden, wobei die zuletzt aufgestellten Seitenteile zwischen die zuerat aufgestellten eingebogen werden, so daß ein extrem enger Spalt zwischen den so gebildeten Seitenwänden verbleibt.

Dieses Fertigungaverfahren ermöglicht die Verwendung einer numerisch gesteuerten automatischen Werkzeugmaschine. Auf dieser wird in einem ersten Arbeitsgang aus dem Blechband ein Zuschnitt vorgegebener Längs- und Querabmessung in zwei Schritten hergestellt. In einem zweiten Arbeitsgang werden mit einem rechteckigen Stanzstempel in vier Schritten die vier Ecken aus dem Zuschnitt ausgeklinkt, so daß eine kreuzförmige Platte entsteht. In einem dritten Arbeitsgang werden dann in zwei Schritten zwei der gegenüberliegenden Seitenteile der Platte zu Seitenwänden abgewinkelt. Alle diese Arbeitsgänge lassen sich auf einem programmierbaren Stanz- und Biegeautomaten ausführen; Sonderwerkzeuge sind für verschiedene Gehäuseabmessungen nicht erforderlich.

In einem vierten Arbeitsgang werden in zwei Schritten die beiden übrigen gegenüberliegenden Seitenteile des kreuzförmigen Zuschnittes abgewinkelt. Hierbei wird der Zuschnitt jeweils innenseitig der Abwinkelungen so von einem passenden Innenstempel gehalten, daß sich diese Seitenteile jeweils abgewinkelt zwischen den bereits im dritten Arbeitsgang aufgestellten Seitenwänden mit geringer Spaltweite und bündig abschließend befinden. Nur für diese eine Gehäuseabmessung, nämlich die durch die eingebogene Seitenwand bestimmte, wird somit ein einfacher rechteckiger Innenhaltestempel entsprechender Breite benötigt. Die äußere Biegebakke für dieses Biegen kann lang durchgehend sein, hat also keine durch das Gehäuse bestimmte Länge. Ein solcher für eine Gehäuseart passender rechteckiger Innenstempel ist jedoch mit relativ geringem Aufwand zu erstellen. Der Innenstempel läßt sich vorteilhaft auch aus einer Anzahl von Teilstempeln, die vorzugsweise eine binär gestaffelte Breite aufweisen, zusammensetzen, so daß z. B. für 32 verschiedene Gehäusebreiten nur fünf verschiedene Teilstempel benötigt werden, von denen jeweils in den verschiedenen Kombinationen die passenden Teilstempel zusammenzusetzen sind. Beispielsweise lassen sich so verschiedene Gehäusebreiten mit je 1/10 Zoll Normraster-Unterachied herstellen. Fast eine beliebige Anzahl von unterschiedlichen Gehäusen läßt sich also programmgesteuert ohne spezielle Werkzeugerstellung fließbandmäßig herstellen.

Zwischen den verschiedenen Arbeitsgängen und Schritten wird das Werkstück geeignet zu den Werkzeugen positioniert und dann gehalten; der Innenhaltestempel wird programmgesteuert aus den notwendigen Teilstempeln jeweils zusammengefügt.

In einem fünften Arbeitsgang werden die Spalte zwischen den abgewinkelten Seitenwänden mit einem geeigneten Kupferhartlot in einem Schutzgas-Durchlaufofen abgedichtet. Diese Art der Hartlötung genügt den Anforderungen einer Heliumdichtigkeit von $10^{-8}$.

Danach werden die Löcher für die Elektrodendurchführungen mit einer Hochfrequenz-Bohrmaschine, z.B. mit 60000 Umdrehungen pro Minute, positionsgerecht in schneller Folge eingebracht. Vorzugsweise im gleichen Arbeitsgang läuft ein Fräser am Gehäuserand entlang, der eine Egalisierung der Randfläche auf 1/100 Höhen- und Planheits-Toleranz erbringt. Bei fachgerechter Ausführung der Stanz- und Biegevorgänge liegen auch die Längs- und Querabmessungen in diesem Toleranzbereich. Die Biegeradien und Materialdehnungen bei dem Biegevorgang lassen sich abhängig von der Materialart und Materialdicke in bekannter Weise ermitteln und berücksichtigen.

Außer im Boden der so hergestellten Gehäusewanne lassen sich auch seitlich Bohrungen koordinatengesteuert in diese einbringen, wobei die beliebige Höhe des Gehäuses, von z.B. 15 mm Höhe, es vorteilhaft ermöglicht, besondere Anschlüsse für in mehreren Ebenen eingebrachte Bauteile oder solche die eine relativ hohe Spannung, ein Meßsignal, ein Höchstfrequenz- oder ein optisches Signal führen, in geeigneter Lage unmittelbar auf kürzestem Wege dem zugehörigen Schaltkreispunkt durch geeignet angeordnete Seitenbohrungen mit Durchführungen zuzuführen.

Nach dem Bohren wird das Gehäuse poliert, wonach die Durchführungen mit den Isoliergläsern in bekannter Weise eingeschmolzen werden. Nach Einbau der Schaltkreise wird die Gehäusewanne in bekannter Weise mit einem Deckel dicht verschlossen, der eine umlaufende Randaussparung aufweist, die den Seitenwand-Randbereich aufnimmt.

Eine weitere vorteilhafte Möglichkeit des Verfahrens besteht darin, daß die Ecken des Zuschnittes nicht vollständig ausgestanzt sondern nur freigeschnitten werden. Auf diese Weise verbleiben nach dem Abwinkeln an den Seitenwänden außen Laschen stehen, die Befestigungs- und/oder Kühlzwecken dienen können. Geeignete Befestigungsbohrungen können beim Freischnitt bereits mitgestanzt werden. An der oder den Seitenwänden oder zumindest in deren Nähe werden vorteilhaft im Gehäuse Kühlbleche, die vorzugsweise aus Molybdän bestehen, eingelötet, geschweißt oder geklebt, die die Wärme aus den aufgebrachten Schaltkreisteilen abführen. Die durch das Verfahren des Aufbiegens und Verlötens der Seitenwände ermöglichte große Bauhöhe des Gehäuses bietet vielfältige neue Ausgestaltungs- und Verwendungs-Möglichkeiten.

Es besteht jedoch auch ein Bedarf an Gehäusen für Hybridschaltkreise, die bei minimalem Platz- und Gewichtsbedarf in einen gegebenen nicht rechteckig geformten, z.B. kreisförmigen oder polygonen, Montageraum platzausnutzend eingesetzt werden können. Als besonderes Anwendungsgebiet sei hier der Montageraum eines zylindrischen Flugkörpers, der insbesondere bezüglich seiner Transportkosten sehr kostspielig ist, erwähnt, in den mehrere Gehäuse sich radial erstreckend einzubringen sind.

Nach einer weiteren Verfahrensausgestaltung ist es möglich, Hybridschaltkreisgehäuse höchster Qualitätsanforderungen auch in kleinen Stückzahlen sowie mit kundenspezifischer Kontaktlage und -anzahl auch mit Sonderquerschnittsformen wirtschaftlich zu fertigen. Dabei wird der in seinen Eckbereichen ausgeklinkte oder freigeschnittene Zuschnitt von dem sich somit freistehende Seitenteile erstrecken, im Biegearbeitsgang mit seinem Gehäuseboden zwischen einem Haltestempel und einem Innenstempel, dessen äußere Kontur einem vorgegebenen freien Innenquerschnitt des Gehäuses entspricht, diesem entsprechend orientiert, gefaßt und eingeklemmt, und dann wird der Zuschnitt jeweils in eine Lage verbracht, in der die Seitenteile mindestens um eine Höhe der Seitenwände parallel zu Biegebacken liegen, die jeweils dem Innenstempel in einem Abstand, der der Dicke des Bleches entspricht, benachbart angeordnet sind.

Dieses Fertigungsverfahren ermöglicht die Verwendung einer numerisch gesteuerten, automatischen Werkzeugmaschine. Auf dieser wird in einem Zuschneidearbeitsgang aus dem Blechband ein Zuschnitt vorgegebener Kontur hergestellt, die den Gehäuseboden mit den ausgebreiteten Seitenteilen umfaßt. In einem zweiten Arbeitsgang werden mit jeweils den Ausschnitten gemäßen Stanzstempeln die Freischnitte und/oder Ausschnitte aus dem Zuschnitt ausgeklinkt, so daß die Seitenteile freiliegen. In einem Biegearbeitsgang werden dann die Seitenteile als Seitenwände des Gehäuses abgewinkelt. Alle diese Arbeitsgänge lassen sich auf einem programmierbaren Stanz- und Biegeautomaten mit einem Stanzwerkzeugsatz verschiedener Schnittöffnungswinkel und einem Satz von Biegestempeln verschiedener Breite ausführen; Sonderwerkzeuge sind

EP 0 441 785 B1

für verschiedene Gehäuseabmessungen nicht erforderlich.

Beim Biegen wird die Platte jeweils innenseitig der Abwinkelung so von einem passenden Innenstempel gehalten, daß sich jeweils Stirnflächen der Seitenwände mit geringer Spaltweite an die benachbarte Seitenand anschließen. Durch die Breite oder Innenkontur der einzubiegenden Seitenwände bestimmt, wird somit jeweils ein entsprechender, einfacher Innenhaltestempel für das Biegen benötigt. Die äußere Biegebacke für dieses Biegen kann durchgehend sein; sie hat also keine durch das Gehäuse bestimmte Länge, sondern wird jeweils entsprechend dem Biegekantenverlauf positioniert.

Zwischen den verschiedenen Arbeitsgängen und Stanz- und Biegeschritten wird das Werkstück geeignet zu den Werkzeugen positioniert und gehalten; der Innenhaltestempel wird programmgesteuert jeweils aus einem Vorrat verschieden breiter Stempel ausgewählt.

In einer für mittlere Serien besonders vorteilhaften Verfahrensausgestaltung wird der Biegearbeitsgang in einem Schritt ausgeführt. Hierzu wird jeweils ein zu der Gehäuseform passender Innenstempel und eine Matrize benötigt, die aus einsetzbaren und/oder in ihrem Abstand zueinander einstellbaren Biegebacken der äußeren Gehäusekontur entsprechend zusammenzusetzen und einzustellen ist. Der Innenstempel und die Matrize werden in eine Presse eingesetzt, und der Zuschnitt wird vor dem Biegevorgang in der Matrize durch seitliche Anschläge positioniert.

Vorzugsweise besteht die Matrize aus zwei zueinander parallelen, im Abstand zueinander einstellbaren Backen, zwischen denen den weiteren äußeren Gehäusekonturabschnitten entsprechend Backensegmente eingesetzt sind. Somit können viele Gehäuseformen durch wenige Backensegmente und entsprechende Backeneinstellung hergestellt werden. Die passenden Innenstempel zu verschiedenen Gehäuseformen sind verhältnismäßig einfach herzustellen. Bodenseitig ist in der Matrize jeweils ein Gegenhalter und Auswerfer verschieblich angeordnet, der auf einem Kraftgeber abgestützt ist.

In einem nachfolgenden Arbeitsgang werden die Spalte zwischen den abgewinkelten Seitenwänden mit einem geeigneten Kupferhartlot in einem Schutzgasdurchlaufofen abgedichtet. Diese Art der Hartlötung genügt den Anforderungen einer Heliumdichtigkeit von $10^{-8}$.

In den Figuren 1 bis 11 sind die verschiedenen Fertigungszustände eines Gehäuses, sowie Werkzeuge zu deren Herstellung dargestellt.

Fig. 1 zeigt einen Zuschnitt mit ausgeklinkten Ecken;

Fig. 2 zeigt den Fertigungszustand nach dem dritten Arbeitsgang, mit den ersten Seitenteilen;

Fig. 3 zeigt eine Gehäusewanne mit eingesetzten Boden-Kontaktdurchführungen;

Fig. 4 zeigt einen Zuschnitt mit Freischnitten;

Fig. 5 zeigt eine Gehäusewanne mit Befestigungs- und Kühllaschen;

Fig. 6 zeigt einen Zuschnitt eines trapezförmigen Gehäuses;

Fig. 7 zeigt einen Zuschnitt eines etwa halbkreisförmigen Gehäuses;

Fig. 8 zeigt eine Aufsicht eines Biegewerkzeuges;

Fig. 9 zeigt einen geteilten Schnitt eines Biegewerkzeuges;

Fig. 10 zeigt eine Unteransicht eines Gehäusedeckels;

Fig. 11 zeigt einen Querschnitt eines geschlossenen Gehäuses.

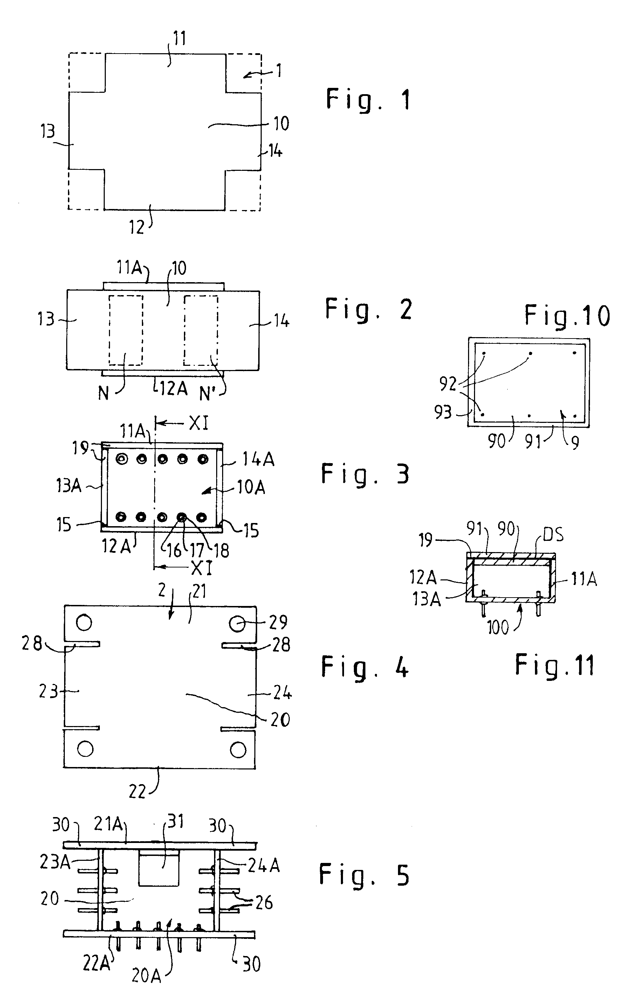

Fig. 1 zeigt einen Zuschnitt (1), dessen Ecken im zweiten Arbeitsgang ausgeklinkt worden sind, so daß eine kreuzförmige Platte mit einem Bodenbereich (10) verblieben ist. Ein sich gegenüberliegendes Armpaar von Seitenteilen (11, 12) ist etwa um die Materialstärke länger als das andere, senkrecht zum ersten orientierte Armpaar von Seitenteilen (13, 14) ausgebildet. Die genauen Abmessungen der Armlängen ergeben sich durch einfache Biegeversuche mit dem jeweiligen Gehäusematerial.

Fig. 2 zeigt den U-förmig ausgebildeten Körper nachdem im dritten Arbeitsgang nacheinander zwei der Seitenteile zu Seitenwänden (11A, 12A) aufgebogen worden sind. Im vierten Arbeitsgang werden dann die anderen Seitenteile (13, 14) zwischen die bereits hochgebogenen Seitenwände (11A, 12A) gebogen, so daß die so entstehenden Seitenwände mit deren Endflächen bündig abschließen, wobei der Innenstempel (N, N') sich jeweils in der gestrichelten bzw. strichpunktierten Stellung befindet.

Fig. 3 zeigt eine fertige Gehäusewanne (10A), deren Spalte (15) zwischen den Seitenwänden (11A - 14A) in den Eckbereichen hart verlötet sind. Der Lötspalt (15) ist nur wenige zehntel Millimeter weit. Bodenseitig sind im genormten Raster Elektrodendurchführungen (16) mittels einer Glaseinschmelzung (17) in die Bohrungen (18) eingesetzt. Die obenliegende Randfläche (19) der Seitenwände (11A - 14A) ist eng toleriert plan geschliffen. Der Schleifvorgang der Randfläche (19) erfolgt vorteilhaft beim Durchlauf des Gehäuses im Bohrarbeitsgang relativ zum Bohrkopf und zum Schleifwerkzeug.

Fig. 4 zeigt einen andersartigen Zuschnitt (2), bei dem um den Boden (20) Freischnitte (28) eingebracht sind, die die Seitenteile (21 - 24) freilegen. In den stehengebliebenen Eckbereichen sind mit der Einbringung der Freischnitte (28) Befestigungslöcher (29) eingestanzt.

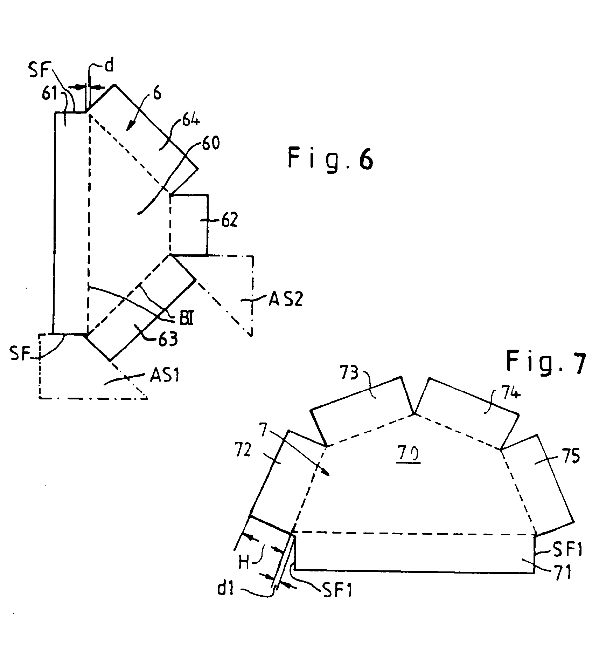

Fig. 5 zeigt eine aus dem Zuschnitt gemäß Fig. 4 fertiggestellte Gehäusewanne (20A), deren im dritten

4

Arbeitsgang gebogenen Seitenwände (21A,22A) die aus den stehengebliebenen Eckbereichen gebildeten Kühl- und Befestigungslaschen (30) mit den Befestigungslöchern tragen. Die Seitenwände (23A,24A) sind mit Bohrungen versehen, in die Durchführungsstifte (26) isoliert eingesetzt sind. An der Seitenwand (21A mit den Befestigungslaschen (30) ist innenseitig in der Gehäusewanne (20A) eine Kühlfahne (31) für die Montage eines Leistungsschaltkreises befestigt.

Fig. 6 zeigt einen zuschnitt (6) eines trapezförmigen Gehäuses, das insbesondere zum Einbau in einen Quadranten eines runden Einbauraumes geeignet ist. Im Bereich der Basis- und Dachkante des Trapezes entstehen im Einbauraum günstige Verdrahtungs- und Luftführungskanäle. Entsprechend der Seitenwandhöhe (H) erstrecken sich in dem trapezförmigen Bodenbereich (60) die Seitenteile (61 - 64), die durch Ausstanzung der Eckbereiche mit einem spitzwinkligen und mit einem stumpfwinkligen Stempel (AS1, AS2) - strichpunktiert gezeichnet - jeweils nach entsprechender Positionierung des Zuschnittes entstehen. Die Eckpunkte der stumpfwinkligen Ausstanzungen sind vorzugsweise gegenüber der Lage der gestrichelt eingezeichneten Biegestempel-Innenkante (BI) jeweils so um eine Materialstärke (d) versetzt positioniert, daß die Stirnflächen (SF) des einen Seitenteiles (61) nach dem Biegen jeweils gegenüberliegend zu der benachbarten Seitenwand aus dem Seitenteil (63, 64) liegen und so nur ein enger Spalt dazwischen entsteht. Die spitzwinkligen Eckausschnitte enden vorzugsweise auf den Biegelinien, der Lage der Biegestempel-Innenkante (BI), da die Stirnflächen der benachbarten Seitenteile (62, 63; 62, 64) dadurch jeweils, wenn sie hochgebogen sind, stirnseitig im spitzen Winkel eng benachbart zueinander liegen.

Fig. 7 zeigt einen Zuschnitt (7) einer weiteren vorteilhaften Gehäuseform, die im Querschnitt etwa einen Halbkreis bildet und besonders für den paarweisen, radialen Einbau in einen zylindrischen Montageraum geeignet ist. Die Ausstanzungen an den Ecken der Basislinie sind so zu der Biegelinie, d.h. der Innenstempelkante, die gestrichelt dargestellt ist, um die Materialstärke (d1) versetzt, daß die Stirnflächen (SF1) der Basislinien-Seitenwand (71) hochgebogen jeweils vor der benachbarten Seitenwand (72, 75) liegen. Die Zahl und der Winkel der spitzwinkligen Ausschnitte, die zweckmäßig in einer Gleichverteilung auf dem Abschnitt des Kreisumfanges angeordnet sind, richtet sich nach der Genauigkeit der Annäherung an die Kreiskontur, die gefordert ist und nach der Höhe (H) der Seitenfläche. Es empfiehlt sich, falls eine kreisabschnittförmige Innenstempelkontur benutzt wird, die Zahl der Einschnitte um so größer zu wählen, je größer die Höhe (H) ist, damit die Verformungen relativ gering bleiben, die beim Biegen der Seitenteile erfolgen.

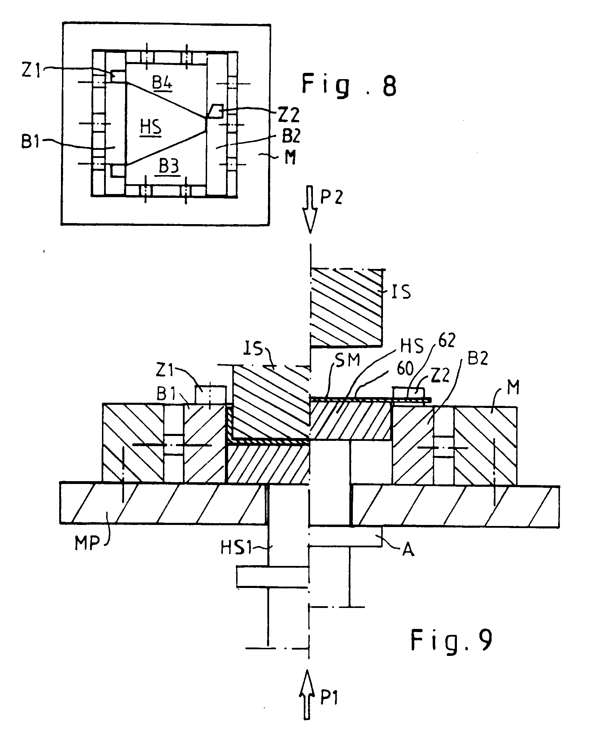

Fig. 8 zeigt ein universelles Biegewerkzeug, dessen Matrize durch veränderliche Einsätze jeweils sehr leicht und kostengünstig verschiedenen Gehäuseformen anzupassen ist. Das Werkzeug besteht aus einem quadratischen Montagerahmen (M), in den in ihrem Abstand einstellbare Backen (B1, B2) und auswechselbare Backen (B3, B4) eingesetzt und befestigt sind, so daß der verbleibende innere Raum den Matrizenraum bildet. In den Eckbereichen der aufzulegenden Zuschnitte sind Zentrierplatten (Z1, Z2) auf den Backen (B1, B2) befestigt. Der Boden der Matrize ist verschieblich angeordnet, so daß er als Halter und als Auswerfer dient.

Fig. 9 zeigt einen querschnitt durch die Biegevorrichtung, mit der in einem Schritt der Biegevorgang durchgeführt werden kann und die hohe Präzision der Außenabmessungen des Gehäuses erbracht wird, wobei die linke Hälfte die Endlage der Stempel (IS, HS) nach dem Biegevorgang und die rechte Hälfte die Ausgangsstellung nach dem Beschicken des Werkzeuges mit dem Zuschnitt (60, 62) zeigt.

Auf der Montageplatte (MP) ist der Montagerahmen (M) befestigt, zwischen dem die Biegebacken (B1, B2) fixiert sind, so daß sie die geforderte Außenkontur des Gehäuses umfassen. Zwischen den Biegebacken (B1, B2) ist der Haltestempel (HS) axial verschieblich gelagert. Er ist mit einem Haltestempelschaft (HS1) durch die montageplatte (MP) hindurchgeführt und stützt sich auf einen Kraftgeber ab, der ein Federpaket oder ein Hydraulikzylinder ist, der die Haltekraft (P1) aufbringt. Der Haltestempelschaft (HS1) und der Kraftgeber sind durch einen Anschlag (A) an der Montageplatte (MP) so abgestützt, daß die freie Stirnfläche (SM) des Haltestempels (HS) etwas oberhalb der zu ihr parallelen Flächen der Biegebacken (B1, B2) liegt und somit etwas aus der Matrize herausragt (rechter Bildteil). Auf diese Stirnfläche (SM) wird der Zuschnitt mit dem Gehäuseboden (60) zwischen die Zentrierplatten (Z1, Z2) aufgelegt, wobei der Innenstempel (IS) zur Matrize ausreichend beabstandet ist.

Beim Biegevorgang wird der Innenstempel (IS) durch einen Kraftgeber axial auf die Matrize zubewegt, so daß er den Gehäuseboden (60) erfaßt und entsprechend der Gegenhaltekraft (P1) diesen einklemmt, wonach er den Zuschnitt um mindestens die Seitenwandhöhe zwischen die Biegebacken (B1, B2) verbringt. Dabei ist der Abstand der Biegebacken (B1, B2) zu dem Innenstempel (IS) etwa gleich der Materialstärke des Bleches. In der Endstellung des Haltestempels (HS) stützt sich dieser auf der Montageplatte (MP) ab, wobei der Innenstempel (IS) mit einer Preßkraft (P2) angedrückt wird, die weit höher als die Haltekraft (P1) ist, so daß eine plane Ausformung des Gehäusebodens erbracht wird. Anschließend wird der Innenstempel (IS) zurückgeholt, und der Haltestempel (HS) als Auswerfer betätigt.

Fig. 10 zeigt einen neuartigen, nach einem vorteilhaften Verfahren hergestellten Deckel (9) für das Gehäuse, von der Wannenseite aus gesehen. Im Gegensatz zu den bekannten Deckeln, die aus einem Blechzu-

5

schnitt durch Abätzen des Randbereiches zur Aufnahme des Wannenrandbereiches hergestellt wurden, besteht dieser aus zwei dünnen Blechzuschnitten (90, 91), von denen der, eingesetzt in die Gehäusewanne innenliegende, Zuschnitt (90) randseitig mit der Innenkontur die Gehäusewanne mit geringem Spiel abschließt und der darüberliegende Deckelzuschnitt (91) den Gehäusewannenrand überdeckt. Die beiden Zuschnitte (90, 91) sind durch Punktschweißungen (92) miteinander fixiert. Der sich somit ergebende umlaufende stufenförmige Randbereich (93) hat keinen störenden Rundungsübergang, den die herkömmliche Ätztechnik erzeugte.

Fig. 11 zeigt einen Querschnitt eines fertigen verschlossenen Gehäuses (100) entsprechend Schnitt XI-XI in Fig.3 Auf der Randfläche (19) der Seitenwände (11A, 12A) liegt der Deckelzuschnitt (91) auf, und zwischen den Seitenwänden (11A, 12A, 13A) liegt der innere Deckelzuschnitt (90). Bei der Verlötung des Deckels mit der Gehäusewanne wird ein Kupferhartlot eingefügt, das beim Lötvorgang in dem Schutzgasdurchlaufofen sowohl den stufenförmigen Spalt zwischen der Wanne und dem Deckel ausfüllt, als auch den Spalt (DS) zwischen den beiden Deckelzuschnitten (90, 91) ausfüllt. Dadurch erhält der Deckel seine volle Festigkeit die sich gemäß der Gesamtdicke der beiden Deckelzuschnitte ergibt. Aus Gründen der Biegefestigkeit ist vorzugsweise der innere Zuschnitt (90) dicker als der äußere. zur Kostenersparnis sind die beiden Deckelzuschnitte aus verschiedenen Materialien hergestellt, wobei vorzugsweise außenliegend vernickeltes Covar und innenliegend reines Nickel verwandt ist, weil letzteres durch Einsparung eines Vernickelungsvorganges preisgünstiger als das Covar ist.

Sowohl die neuartige Gehäusewanne als auch der neuartige Deckel sind vorteilhafte Zwischenprodukte einzelner neuartiger Verfahrensabschnitte des Gesamtverfahrens.

## Patentansprüche

1. Verfahren zur Herstellung eines Gehäuses, insbes. zur Aufnahme eines Hybridschaltkreises, durch eine Verformung eines Zuschnittes (1, 2, 6, 7) eines Bleches zu einer Gehäusewanne (10A, 20A), ein anschließendes Einbringen von Löchern (18) in diese Gehäusewanne (10A), ein Einschmelzen je einer Durchführung (16) mittels einer Glaseinschmelzung (17) in die Löcher (18), ein Planschleifen der Randfläche (19) der Gehäusewannenwandung (11A - 14A) und danach ein dichtes Hartverlöten des Gehäuses (100) mit einem Deckel (9), der in einer umlaufenden Ausnehmung (93) einen Randbereich der Gehäusewannenwandung (11A - 14A) aufnimmt, dadurch gekennzeichnet, daß
der Zuschnitt (1, 2, 6, 7) jeweils in den Eckbereichen ausgeklinkt oder freigeschnitten wird, so daß sich an dem Zuschnitt (1, 2, 6, 7) freistehende Seitenteile (11 - 14; 21 - 24; 61 - 64; 71 - 75) erstrecken, die, die Seitenteile (11 - 14; 21 - 24; 61 - 64; 71 - 75) der Gehäusewanne (10A, 20A) bildend, danach jeweils in einem Biegearbeitsgang zu an einen Gehäuseboden (10, 20, 60, 70) anschließenden Seitenwänden (11A - 14A) abgewinkelt werden, so daß jeweils die benachbarten Seitenwände (11A-14A) mit einem engen Spalt (15) zueinander stehen, wonach diese Spalte (15) durch ein Hartlöten verschlossen werden, woran sich das Einbringen der Löcher (18) anschließt.

2. Verfahren nach Anspruch 1, dadurch gekennzeichnet, daß die Ecken des Zuschnittes (1, 2) so freigeschnitten oder ausgeklinkt werden, daß die Seitenteile (11, 12; 13, 14) gekreuzte Armpaare bilden und die Seitenteile (11, 12) des ersten Armpaares jeweils etwa um eine Blechdicke weiter ausgestreckt sind als die anderen Seitenteile (13, 14).

3. Verfahren nach Anspruch 1 oder 2, dadurch gekennzeichnet, daß beim Freischneiden entlang der Seitenteile (23, 24) des zweiten Armpaares Freischnitte (28) eingebracht werden, durch die Laschen (30) in den Ecken zumindest an einem Seitenteil (21) des ersten Armpaares stehen bleiben.

4. Verfahren nach Anspruch 3, dadurch gekennzeichnet, daß in die Laschen (30) mit dem Freischnitt (28) Befestigungslöcher (29) eingestanzt werden.

5. Verfahren nach Anspruch 1 oder 2, dadurch gekennzeichnet, daß während des Abwinkelns der Seitenteile (13, 14) des zweiten Armpaares der Zuschnitt (1) jeweils durch einen Innenstempel (N, N') gehalten wird, der aus Teilstempeln zusammengesetzt ist, deren Gesamtbreite annähernd der Breite der Seitenteile (13, 14) des zweiten Armpaares entspricht.

6. Verfahren nach Anspruch 5, dadurch gekennzeichnet, daß die Teilstempel für das Zusammensetzen jeweils aus einer Vielzahl von Teilstempeln programmgesteuert ausgewählt werden, die in ihrer Breite zueinander binär gestaffelt ausgestaltet sind.

7. Verfahren nach einem der Ansprüche 1 bis 6, dadurch gekennzeichnet, daß in dem Biegearbeitsgang der Gehäusebodenbereich (10, 20, 60, 70) zwischen einem Haltestempel (HS) und einem Innenstempel (IS), dessen äußere Kontur einem vorgegebenen freien Innenquerschnitt des Gehäuses entspricht, diesem entsprechend orientiert, gefaßt und eingeklemmt wird und dann der Zuschnitt (1, 2, 6, 7) jeweils in eine Lage verbracht wird, in der die Seitenteile (11 14; 21 - 24; 61 - 64; 71 - 75)) mindestens um eine Höhe (H) der Seitenwände (11A, 14A) parallel zu Biegebacken (B1, B4) liegen, die jeweils dem Innenstempel (IS) in einem Abstand, der der Dicke (d) des Bleches entspricht, benachbart angeordnet sind.

8. Verfahren nach Anspruch 7, dadurch gekennzeichnet, daß der zwischen dem Innenstempel (IS) und dem Haltestempel (HS) eingeklemmte Zuschnitt (1, 2, 6, 7) nacheinander zu einer oder mehreren der Biegebacken (B1, B4) in die benachbarte Stellung positioniert wird.

9. Verfahren nach Anspruch 8, dadurch gekennzeichnet, daß die Biegebacken (B1 - B4) auf einer Montageplatte (MP) so angeordnet sind, daß sie nach Art einer Matrize eine gegebene Außenkontur des Gehäuses passend umfassen, und daß der zwischen dem Haltestempel (HS) und dem Innenstempel (IS) eingeklemmte Zuschnitt (1, 2, 6, 7) in Richtung auf die Montageplatte (MP) zwischen die Biegebacken (B1, B4) verbracht wird und daß der Haltestempel (HS) zwischen den Biegebacken (B1 - B4) passend und axialverschieblich angeordnet ist und mittels eines Haltestempelschaftes (HS1), der in der Montageplatte (MS) axialverschieblich gelagert ist, zwischen zwei Lagen verbracht wird, wobei in der ersten Lage die Stirnfläche (SM) des Haltestempels (HS) sich etwas oberhalb der gleichgerichteten freien Flächen der Biegebacken (B1, B4) befindet und in der zweiten Lage diese Stirnfläche (SM) sich um mindestens die Höhe (H) versetzt gegen die gleichgerichteten freien Flächen der Biegebacken (B1 - B4) innerhalb dieser Biegebacken (B1, B2) befindet.

10. Verfahren nach Anspruch 9, dadurch gekennzeichnet, daß der Zuschnitt (1, 2, 6, 7) vor dem Einklemmen zwischen Anschlägen (Z1, Z2) orientiert wird, die in mindestens zwei der Eckbereiche passen und jeweils an einer der Biegebacken (B1 - B4) passend befestigt sind.

11. Verfahren nach einem der vorstehenden Ansprüche, dadurch gekennzeichnet, daß die Löcher (18) mit einem programmgesteuerten hochtourigen Koordinaten-Bohrwerk bodenseitig oder seitlich in die Gehäusewanne (10A, 20A) gebohrt werden.

12. Verfahren nach Anspruch 11, dadurch gekennzeichnet, daß gleichzeitig mit dem Bohren und/oder dem jeweiligen Positionieren zwischen den einzelnen Bohrvorgängen das Planschleifen erfolgt.

13. Verfahren nach Anspruch 1, dadurch gekennzeichnet, daß der Deckel (9) aus einem ersten, innenseitig in die Gehäusewanne (10A) passenden Deckel-Blechzuschnitt (90) und einem weiteren größeren Deckel-Blechzuschnitt (91) so durch Punktschweißungen (92) verbunden wird, daß um den ersten Deckel-Blechzuschnitt (90) die randseitig umlaufende Ausnehmung (93) gebildet ist.

## Claims

1. Process for manufacturing a casing, more particularly one to house a hybrid circuit, by deforming a sheet metal blank (1, 2, 6, 7) into a casing box (10A, 20A), next making holes (18) in said box (10A), sealing in a bushing (16) into each of the holes (18) by means of a glass seal (17), surface grinding the rim (19) of the box walls (11A - 14A) and then tightly brazing the casing (100) with a lid (9) in which a rim area of the walls (11A - 14A) of the box is received in a continuous recess (93),
characterised by punching out or cutting away the blank (1, 2, 6, 7) in each of its corner regions, so that free-standing side panels (11 - 14; 21 - 24; 61 - 64; 71 - 75) extend along the blank (1, 2, 6, 7) which, forming the side panels (11 - 14; 21 - 24; 61 - 64; 71 - 75) of the casing box (10A, 20A), are then each folded up in a bending operation to form side walls (11A - 14A) adjoining a box base (10, 20, 60, 70), leaving a narrow gap (15) between respective adjacent side walls (11A - 14A) which is then sealed by hard soldering, following which the holes (18) are introduces.

2. Process according to claim 1, characterised in that the corners of the blank (1, 2) are cut away or punched out in such a way that the side panels (11, 12; 13, 14) form cruciform pairs of arms and the side panels (11, 12) of the first pair of arms are each stretched further than the other side panels (13, 14) by approximately the thickness of the metal sheet.

3. Process according to claim 1 or 2, characterised in that when the side panels (23, 24) of the second pair of arms are cut a way, this introduces cutaways (28) by means of which tabs (30) are left in the corners at least on one side panel (21) of the first pair of arms.

4. Process according to claim 3, characterised in that attachment holes (?9) are punched in the tabs (30) with the cutaway (28).

5. Process according to claim 1 or 2, characterised in that while the side panels (13, 14) of the second pair of arms are being bent back, the blank (1) is in each case retained by an inner punch (N, N') made up of constituent punches, the overall width of which more or less matches the width of the side panels (13, 14) of the second pair of arms.

6. Process according to claim 5, characterised in that the constituent punches for assembly are respectively selected as programmed from a large number of constituent punches whose widths are designed to be binary staggered with respect to one another.

7. Process according to one of claims 1 to 6, characterised in that in the bending operation the casing floor area (10, 20, 60, 70) is aligned, gripped and clamped relative to the casing between a holding punch (HS) and an inner punch (IS) the outer contour of which matches a given overall inside cross-section of the casing, and then the blank (1, 2, 6, 7) is in each case moved into a position in which the side panels (11 - 14; 21 - 24; 61 - 64; 71 - 75) are situated parallel to bending jaws (B1, B2) by no less than the height (H) of the side walls (11A, 14A), said bending jaws (B1, B2) being spaced alongside the inner punch (IS) by a distance equivalent to the thickness (d) of the sheet metal.

8. Process according to claim 7, characterised in that the blank (1, 2, 6, 7) clamped between the inner punch (IS) and the holding punch (HS) is successively moved into the adjacent position relative to one or more of the bending jaws (B1, B4).

9. Process according to claim 8, characterised in that the bending jaws (B1 - B4) are disposed on a mounting plate (MP) in such a way that they fit around a given external contour of the casing in the manner of a die, and that the blank (1, 2, 6, 7) clamped between the holding punch (HS) and the inner punch (IS) is moved in the direction of the mounting plate (MP) between the bending jaws (B1, B4) and that the holding punch (HS) is disposed so as to fit between the bending jaws (B1 - B4) and be axially displaceable therebetween and is moved between two positions by means of a holding punch shaft (HS1) mounted so as to be axially displaceable in the mounting plate (MP), in the first position the end face (SM) of the holding punch (HS) being situated somewhat above the similarly directed free faces of the bending jaws (B1, B4) and in the second position said end face (SM) being offset by at least the height (H) towards the similarly directed free faces of the bending jaws (B1 - B4) within said bending jaws (B1, B2).

10 Process according to claim 9, characterised in that before it is clamped the blank (1, 2, 6, 7) is aligned between stops (Z1, Z2) which fit into at least two of the corner regions and are each fitted on one of the bending jaws (B1 - B4).

11. Process according to one of the preceding claims, characterised in that the holes (18) are drilled by a program-controlled high-speed coordinate drilling machine from the bottom or sideways into the casing box (10A, 20A).

12. Process according to claim 11, characterised in that surface-grinding is carried out at the same time as the drilling and/or the respective positioning between the various drilling operations.

13. Process according to claim 1, characterised in that the lid (9) is combined by spot welds (92) from a first sheet-metal lid blank (90) which fits inside the casing box (10A) and a further, larger sheet-metal lid blank (91), in such a way that the peripheral recess (93) is formed around the first sheet-metal lid blank (90).

## Revendications

1. Procédé de fabrication de boitier, notamment pour circuits hybrides, par formage en cuvette (10A, 20A) de boitier d'une découpe de tôle (1, 2, 6, 7), suivi de l'exécution de perforations (18), pratiquées dans cette cuvette (10A) de boitier, d'un scellement de traversées (16) par fusion de verre (17) dans chacun des trous (18), d'une rectification plane de la surface des bords (19) de la paroi (11A à 14A) de la cuvette du boitier, puis d'un brasage dur étanche du boitier(100) avec un couvercle (9), recevant une zone marginale de la paroi (11A à 14A) de la cuvette du boitier dans une cavité (93) qui s'étend sur la totalité du périmètre, caractérisé par le fait que

la découpe (1, 2, 6, 7) est dégagée ou encochée dans ses zones angulaires de sorte que des pièces latérales (11 - 14; 21 - 24; 61 - 64; 71 - 75) s'étendent librement de part et d'autre formant les côtés (11 - 14; 21 - 24; 61 - 64; 71 - 75) de la cuvette (10A, 20A) du boitier, et sont ensuite pliées, au cours d'une opération de formage, respectivement en parois latérales (11A - 14A), faisant suite à un fond (10, 20, 60, 70) de boitier, de sorte qu'elles ne soient séparées que par un faible interstice (15), qui est ensuite fermé par brasage fort, ce après quoi les perforations (18) sont pratiquées.

2. Procédé selon revendication 1 caractérisé par le fait que les angles de la découpe (1, 2) sont découpés ou encochés de sorte que les pièces latérales (11, 12, 13, 14) forment une croix, les parties latérales (11, 12), formant les deux premiers bras de cette croix, étant plus longs que les deux autres (13, 14) d'une épaisseur de tôle.

3. Procédé selon revendication 1 ou 2, caractérisé par le fait que, lors du dégagement des pièces latérales (23, 24), formant le second couple de bras de la croix, des encoches 28 sont pratiquées, laissant des languettes (30) dans les coins, tout au moins d'une pièce latérale (21) du premier couple de bras.

4. Procédé selon revendication 3, caractérisé par le fait que des trous de fixation sont pratiqués dans les brides (30) lors du découpage de l'encoche (28).

5. Procédé selon revendication 1 ou 2, caractérisé par le fait que, pendant le pliage des pièces latérales (13, 14) du second couple de bras, la découpe (1) est maintenue à l'aide d'un étançon interne (N, N'), composé de poinçons partiels assemblés, et dont la largeur globale correspond approximativement à la largeur des pièces latérales (13, 14), formant le second couple de bras.

6. Procédé selon revendication 5, caractérisé par le fait que les poinçons partiels à assembler sont sélectionnés, respectivement, par commande par programme, à partir d'un grand nombre de pièces, échelonnées binairement, par rapport les unes aux autres, quant à leur largeur.

7. Procédé selon l'une des revendications de 1 à 6, caractérisé par le fait que, lors de l'opération de formage, la zone du fond du boitier (10, 20, 60, 70) est serrée, adéquatement orientée, entre un poinçon de maintien (HS) et un poinçon interne (IS), dont le contour extérieur correspond à une section transversale interne, libre, prédéterminée du boitier, et que la découpe (1, 2, 6, 7) est alors amenée dans une position, dans laquelle les parties latérales (11, 14; 21; 61 - 64; 71 - 75) sont situées, à au moins une hauteur (H) des parois latérales (11A, 14A), parallèlement aux mâchoires de formage (B1 - B4), disposées à une distance du poinçon interne (IS) correspond à l'épaisseur (d) de la tôle.

8. Procédé selon revendication 7, caractérisé par le fait que la découpe (1, 2, 6, 7), serrée entre le poinçon interne (IS) et le poinçon de retenue (HS) est positionnée, successivement, par rapport à l'une ou à plusieurs des mâchoires de formage (B1, B4).

9. Procédé selon revendication 8, caractérisé par le fait que les mâchoires de formage (B1 - B4) sont disposées sur une plaque de montage (MP) de sorte qu'elles embrassent, comme une matrice, le contour extérieur, prédéterminé du boitier et que la découpe (1, 2, 6, 7), serrée entre le poinçon de retenue (HS) et le poinçon interne (IS), est mue en direction de la plaque de montage (MP), entre les mâchoires de formage (B1, B4) et que le poinçon de retenue (HS) est disposé, adapté entre les mâchoires de formage (B1, B4), et, étant monté, à l'aide d'une tige (HS1), dans la plaque de montage (MP), est déplaçble, axialement, entre deux positions, la partie frontale (SM) du poinçon de retenue (HS) se trouvant un peu au-dessus des surfaces libres des mâchoires de formage (B1 - B4), dans la première position, tandis que cette surface frontale (SM) est décalée d'au moins une hauteur (H) contre les surfaces libres des mâchoires de formage (B1 - B4), à l'intérieur de ces mâchoires de formage (B1, B2), dans la deuxième position.

10. Procédé selon revendication 9, caractérisé par le fait que la découpe (1, 2, 6, 7), avant d'être serrée, est orientée entre des butées (Z1, Z2), fixées adéquatement à l'une des mâchoires de formage (B1 - B4), dans, au moins, deux zones angulaires. avant d'être serrée.

11. Procédé selon l'une des revendications précédentes, caractérisé par le fait que les perforations (18) sont pratiquées dans le fond ou dans les parois latérales de la cuvette (10A, 20A) du boitier avec une perceuses à coordonées à vitesse élevée, commandée par programme.

12. Procédé selon revendication 11, caractérisé par le fait que, la rectification plane a lieu simultanément pendant le forage et/ou le positionnement entre les différentes phases de forage.

13. Procédé selon revendication 1, caractérisé par le fait que le couvercle (9) est composé d'une première découpe de tôle (90), adaptée à l'intérieur de la cuvette du boitier, et d'une autre découpe de tôle (91) plus grande, reliées ensemble par soudure par points, de sorte à former la cavité (93), s'etendant, en continue, autour du bord de la découpe (90) de couvercle.

Fig. 1

Fig. 2

Fig.10

Fig. 3

Fig. 4

Fig.11

Fig. 5

Fig. 6

Fig. 7

Fig. 8

Fig. 9